# EUROPEAN PATENT SPECIFICATION

(11) **EP 0 482 658 B1**
(45) Date of publication and mention of the grant of the patent: **02.07.1997**
(21) Application number: 91118227.7
(22) Date of filing: 25.10.1991
(51) Int. Cl.: H03K 19/00, H03K 19/173, G06F 11/26

(54) **Semiconductor integrated circuit provided with emitter coupled logic input/ output buffers**
Integrierte Halbleiterschaltung mit ECL-Eingangs- Ausgangspuffern
Circuit intégré semi-conducteur comportant des tampons d'entrée/sortie à émetteurs couplés

(30) Priority: 26.10.1990 JP 290460/90
(43) Date of publication of application: 29.04.1992
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi, Kanagawa-ken (JP)
(72) Inventor: Sakaue, Kenji, Yokohama-shi, Kanagawa-ken (JP)
(74) Representative: Lehn, Werner, Dipl.-Ing.

(56) References cited:
- US-A- 4 586 242
- PATENT ABSTRACTS OF JAPAN vol. 9, no. 315 (E-365)11 December 1985;& JP-A-60148135
- IEEE Proceedings of the 1990 Bipolar Circuits Technology Meeting, September 17 - 18, 1990, IEEE New York US, pages 128 - 131; R. SHOOKHTIM et al.: "Novel Boundary Scan Circuit and Methodology for ECL/BiCMOS VLSI"

## Description

### PRIOR ART

The present invention relates to a semiconductor integrated circuit. PATENT ABSTRACTS OF JAPAN, vol. 9, no. 315, (E-365), 11 Dec. 1985, & JP-A-60 148 135 discloses a semiconductor integrated circuit having an input buffer, an internal logic circuit, and an output buffer which are commonly connected to a first external power supply terminal. A test circuit connected to a second power supply terminal is also connected to the internal logic circuit. In the usual operating state of the integrated circuit, power is only supplied to the first external terminal such that the test circuit is put into a non-operating condition.

US-A-4 586 242 discloses a semiconductor integrated circuit having a larger integrated circuit chip of which a chip circuit portion is a part. The chip portion comprises a first plurality of first bonding pads which are each separately connected to a buffer of a first kind that operates with a first supply voltage. The larger chip - exclusive of the chip portion - comprises a second plurality of second bonding pads which are each separately connected to a buffer of a second kind that operates with a second voltage different from the first voltage. Each buffer of the second kind is separately connected to a separate corresponding one of the first bonding pads. The chip portion is capable of performing first electrical operations in response to first signals applied to the first bonding pads, and is capable of performing second operations in response to second signals applied to the second bonding pads. After at least one of the second operations has been performed by applying the second signals to the second bonding pads, at least one of the buffers of the second kind is disconnected from its corresponding one of the first pads, by physically severing the corresponding electrically conductive path. All of the buffers of the second kind may be disconnected from all of the corresponding first pads, and the chip portion may be severed completely from the larger chip exclusive of the chip portion. The first operation is the normal operation, whereas the second operation is a test operation for the integrated circuit.

For facilitating to understand the present invention the technical background thereof will be briefly explained hereinafter.

### BACKGROUND OF THE INVENTION

This invention relates to a semiconductor integrated circuit provided with Emitter Coupled Logic (hereinafter referred to as ECL) input/output buffers, and more particularly to a semiconductor integrated circuit provided with ECL input/output buffers capable of reducing power consumption.

Generally, in the case of inputting an input signal of the ECL level from the external to a device such as SRAM or CPU, etc., and outputting an output signal of the ECL level from the above-mentioned device to the external, an ECL input buffer and an ECL output buffer are used, respectively.

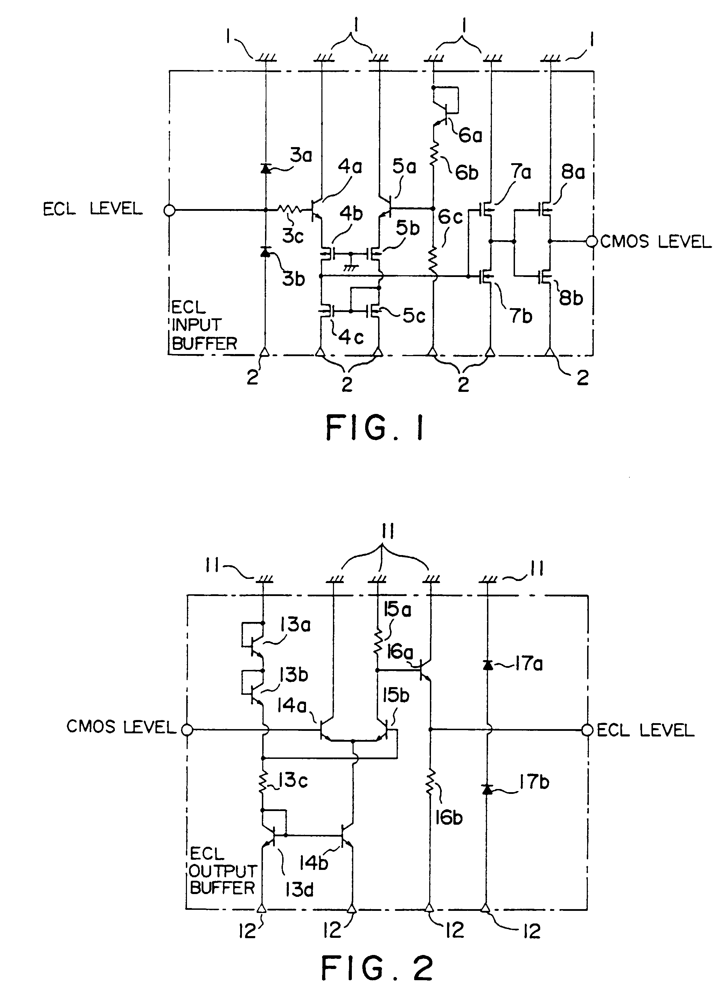

Such ECL input buffer and ECL output buffer are shown in FIGS. 1 and 2, respectively. The ECL input buffer shown in FIG.1 serves to convert an input signal of the ECL level to an output signal of the CMOS level. This ECL input buffer comprises a CMOS circuit comprised of diodes 3a and 3b, a resistor 3c, transistors 4a, 4b, 4c, 5a, 5b and 5c, a transistor 6a, resistors 6b and 6c, and transistors 7a and 7b, and a CMOS circuit comprised of transistors 8a and 8b, and is driven by a first power supply (e.g., a power supply voltage of 0 volts) connected to the terminal 1, and a second power supply (e.g., a power supply voltage of -5.0 volts) connected to the terminal 2.

On the other hand, the ECL output buffer shown in FIG. 2 serves to convert an input signal of the CMOS level to an output signal of the ECL level. This ECL output buffer comprises transistors 13a, 13b and 13d, resistors 13c and 15a, transistors 14a, 14b, 15b and 16a, a resistor 16b, and diodes 17a and 17b, and is driven by a first power supply connected to the terminal 11 and a second power supply connected to the terminal 12. In addition to the input/output buffer of the above-mentioned type, there is known an ECL input/output buffer of the type to receive an input signal of the ECL level to output an output signal of the ECL level. Further, there is also known an ECL input/output buffer of the type driven by a number m (≧ 2) of power supplies.

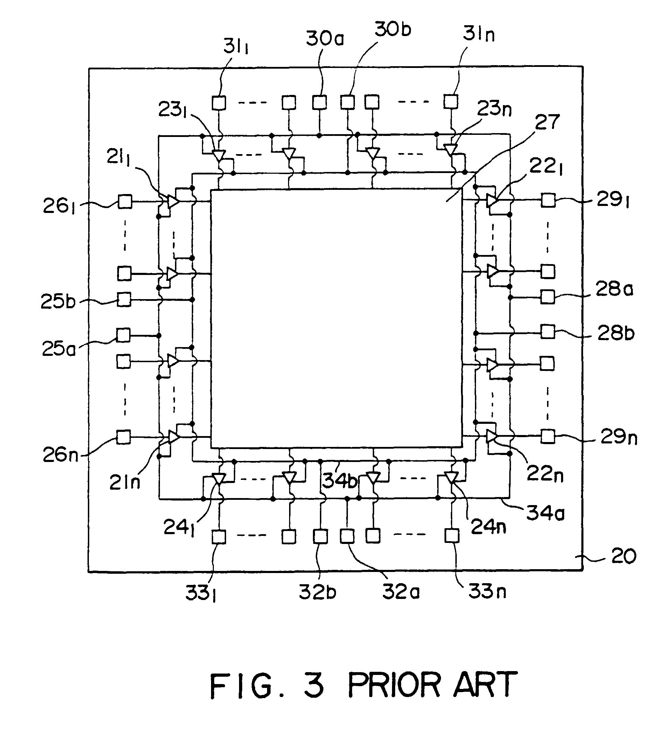

A conventional semiconductor integrated circuit including such ECL input/output buffer is shown in FIG. 3. This semiconductor integrated circuit is provided on a Large Scale Integrated circuit (LSI) chip 20. This semiconductor integrated circuit comprises ECL input buffers 21₁, ... 21ₙ used when the circuit is in an ordinary operating state after assembled into the system, ECL output buffers 22₁, ... 22ₙ used when the circuit is similarly in the ordinary operating state after assembled into the system, test ECL input buffers 23₁, ... 23ₙ used only when the circuit is being assembled into the system and is subject to test, and test ECL output buffers 24₁, ... 24ₙ used only when the circuit is being assembled into the system and is similarly subject to test. In operation, the input buffer circuit 21ᵢ (i = 1, ... n) is driven by a first power supply voltage delivered through a power supply pad 25a and a second power supply voltage delivered through a power supply pad 25b to apply level conversion or waveform shaping to an input signal of the ECL level inputted through a pad 26ᵢ (i = 1, ... n) when the circuit is in an ordinary operating state after assembly to send it to a device (e.g., CPU, etc.) 27 provided at the core section. Further, the output buffer circuit 22ᵢ (i = 1, ... n) is driven by a first power supply voltage delivered through a power supply pad 28a and a second power supply voltage delivered through a power supply pad 28b to apply level conversion to a signal sent from the device when the circuit is in the operating state after assembly to provide an output signal of the ECL level to output it to the external through a power supply pad 29ᵢ.

On the other hand, the test input buffer circuit 23ᵢ (i = 1, ... n) is driven by a first power supply voltage delivered through a power supply pad 30a and a second power supply voltage delivered through a power supply pad 30b to apply level conversion or waveform shaping to an input signal of the ECL level inputted through a power supply pad 31ᵢ (i = 1, ... n) to send it to the device 27. Further, a test output buffer circuit 24ᵢ (i = 1, ... n) is driven by a first power supply voltage delivered through a power supply pad 32a and a second power supply voltage delivered through a power supply pad 32b to apply level conversion to a signal outputted from the device 27 when the circuit is subject to test to provide an output signal of the ECL level to output it to the external through a power supply pad 33ᵢ (i = 1, ... n). Respective terminals to which the first power supply voltages are applied of the input buffers 21₁, ... 21ₙ, the output buffers 22₁, ... 22ₙ, the test input buffers 23₁, ... 23ₙ, and the test output buffers 24₁, ... 24ₙ are connected commonly to a power supply line 34a, and respective terminals to which the second power supply voltages are applied of the above-mentioned buffers are connected commonly to a power supply line 34b.

As seen from FIGS. 1 and 2, the ECL input/output buffer circuit is of a structure in which a current flows therein as long as any drive voltage is applied thereto. Accordingly, in the conventional semiconductor integrated circuit provided with the test ECL input/output buffers, there was the problem that even after such a semiconductor integrated circuit has been assembled into the system, current flows in the test ECL input/output buffers, so power is uselessly consumed.

### SUMMARY OF THE INVENTION

This invention has been made in view of the above-mentioned problems, and its object is to provide a semiconductor integrated circuit permitting the power consumption thereof to be as small as possible.

A semiconductor integrated circuit according to this invention has the features indicated in independent claim 1.

Preferred embodiments of the invention are indicated in dependent claims 2 to 8.

In accordance with the semiconductor integrated circuit of this invention thus constructed, only when the circuit is assembled into the system and is subject to test, the test ECL input buffer circuit and the test ECL output buffer circuit are driven by normal power supply voltages. Further, when the circuit is in an ordinary use state after having been assembled into the system, the number m of drive voltages for driving the test ECL input/output buffers are equal to each other. Accordingly, no current flows in the test ECL input buffer circuit and the test ECL output buffer circuit. As a result, power can be prevented from uselessly consumed as compared to the conventional semiconductor integrated circuit. Thus, power consumption can be as small as possible.

Therefore, in accordance with this invention, an increase in the power consumption can be prevented.

### BRIEF DESCRIPTION OF THE DRAWINGS

In the accompanying drawings;
FIG. 1 is a circuit diagram showing the configuration of an input buffer provided in semiconductor integrated circuits according to the prior art and this invention;
FIG. 2 is a circuit diagram showing the configuration of an output buffer provided in semiconductor integrated circuits according to the prior art and this invention;
FIG. 3 is a circuit diagram showing the outline of the configuration of a conventional semiconductor integrated circuit provided with input/output buffers;
FIG. 4 is a circuit diagram showing the outline of the configuration of a semiconductor integrated circuit provided with input/output buffers according to a first embodiment of this invention; and
FIG. 5 is a circuit diagram showing the outline of the configuration of a semiconductor integrated circuit provided with input/output buffers according to a second embodiment of this invention.

### DETAILED DESCRIPTION OF THE PREFERRED EMBODIMENTS

Preferred embodiments of a semiconductor integrated circuit provided with input/output buffers according to this invention will now be described with reference to the attached drawings.

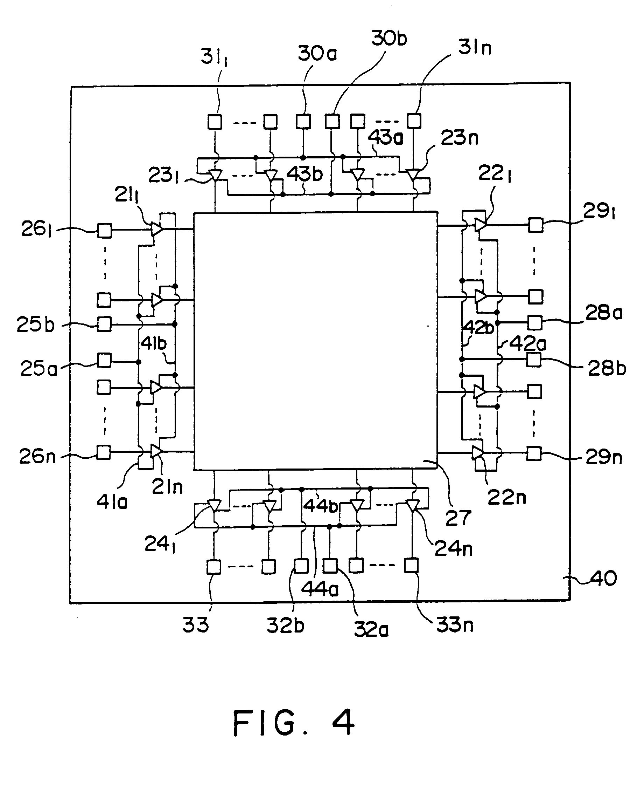

A first embodiment of a semiconductor integrated circuit according to this invention is shown in FIG. 4. The semiconductor integrated circuit of this embodiment is provided on a LSI chip 40. This semiconductor integrated circuit comprises ECL input buffers 21₁, ... 21ₙ used when the circuit is in an ordinary operating state after assembled into the system, ECL output buffers 22₁, ... 22ₙ used when the circuit is similarly in in the ordinary operating state after assembled into the system, test ECL input buffers 23₁, ... 23ₙ used only when the circuit is being assembled into the system and is subject to test, and test ECL output buffers 24₁, ... 24ₙ used only when the circuit is being assembled into the system and is similarly subject to test. This semiconductor integrated circuit differs from the conventional semiconductor integrated circuit in that drive voltage supply lines through which drive voltages for driving the ECL input buffers 21₁, ...21ₙ, the ECL output buffers 22₁, ... 22ₙ, the test input ECL buffers 23₁, ... 23ₙ, and the test ECL output buffers 24₁, ... 24ₙ are delivered, are separately provided on the LSI chip 40, respectively. Namely, first and second drive voltages for driving the ECL input buffers 21₁, ... 21ₙ are delivered to the ECL input buffers 21₁, ... 21ₙ respectively through a power supply pad 25a and a first drive voltage supply line 41a, and a power supply pad 25b and a second drive voltage supply line 41b to drive the ECL input buffers 21₁, ... 21ₙ. Further, first and second drive voltages are delivered to the ECL output buffers 22₁, ... 22ₙ respectively through a power supply pad 28a and a third drive voltage supply line 42a, and a power supply pad 28b and a fourth drive voltage supply line 42b. On the other hand, two drive voltages for driving the test ECL input buffers 23₁, ... 23ₙ are delivered to the test ECL input buffers 23₁, ... 23ₙ respectively through a power supply pad 30a and a fifth drive voltage supply line 43a, and a power supply pad 30b and a sixth drive voltage supply line 43b, and two drive voltages for driving the test ECL output buffers 24₁, ... 24ₙ are delivered to the test ECL output buffers 24₁, ... 24ₙ respectively through a power supply pad 32a and a seventh drive voltage supply line 44a, and a power supply pad 32b and an eighth drive voltage supply line 44b. In addition, these respective first to eighth drive voltage supply lines 41a, 41b, 42a, 42b, 43a, 43b, 44a and 44b are separately provided on the LSI chip 40.

In the semiconductor integrated circuit of the first embodiment, wire bonding is implemented such that only when this semiconductor integrated circuit is being assembled into the system and is subject to test, the first drive voltage is delivered to the power supply pads 30a and 32a, and the second drive voltage is delivered to the power supply pads 30b and 32b, and when this semiconductor integrated circuit is in an ordinary use state after having been assembled into the system, the first drive voltage is delivered to the power supply pads 25a and 28a, and the second drive voltage is delivered to the power supply pads 25b, 28b, 30a, 30b, 32a and 32b. By implementing wire bonding in this way, when the semiconductor integrated circuit is in an operating state except for test state (after it has been assembled), two voltages for driving the test ECL input buffers 23₁, ... 23ₙ and the test ECL output buffers 24₁, ... 24ₙ are equal to each other. As a result, no current flows in the test ECL input buffers 23₁, ... 23ₙ and the ECL output buffers 24₁, ... 24ₙ. Thus, power uselessly consumed can be reduced. It is to be noted that, in the above-described embodiment, pads 31₁, ... 31ₙ and pads 33₁, ... 33ₙ are not subject to wire bonding with respect to the external pads, i.e., the pads 31₁, ... 31ₙ are placed in floating state and the pads 33₁, ... 33ₙ are placed in an open state.

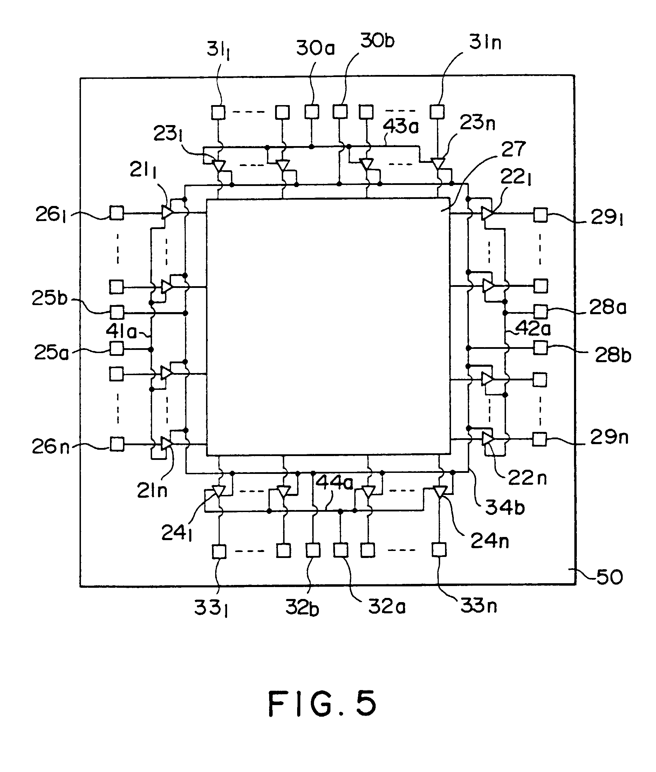

A second embodiment of a semiconductor integrated circuit according to this invention is shown in FIG. 5. The semiconductor integrated circuit of this embodiment is described below. Namely, in the conventional semiconductor integrated circuit shown in FIG. 3, the drive voltage supply line 34a for delivering the first drive voltage to the ordinary ECL input buffer 21ᵢ (i = 1, ... n), the ordinary ECL output buffer 22ᵢ (i = 1, ... n), the test ECL input buffer 23ᵢ (i =1, ... n) and the test ECL output buffer 24ᵢ (i = 1, ... n) is separated on the chip 50 to provide a first group of drive voltage supply lines 41a, 42a, 43a and 44a. Accordingly, there is employed in this embodiment an arrangement such that this first group of drive voltage supply lines 41a, 42a, 43a and 44a respectively correspond to those of the first embodiment, and the other drive voltage supply line 34b corresponds to that of the prior art shown in FIG. 3. At the time of testing this semiconductor integrated circuit, the first drive voltage is applied to the power supply pads 30a and 32a, and the second drive voltage is applied to the power supply pads 30b and 32b, so respective voltages are delivered through the voltage supply lines 43a and 34b. As a result, the test ECL input buffer 23ᵢ (i = 1, ... n) and the test ECL output buffer 24ᵢ (i = 1, ... n) become operative. Thus, a signal of the ECL level provided through the pad 31ᵢ from the external is sent to the device 27 (e.g., CPU, etc.) provided on the core section through the ECL input buffer 23ᵢ. Further, a signal from the above-mentioned device 27 is converted to a signal of the ECL level by the ECL output buffer 24ᵢ through the drive voltage supply lines 34b and 44a, and is then outputted to the external through the pad 33ᵢ. Thus, test of the semiconductor integrated circuit is carried out.

Furthermore, wire bonding is implemented such that when this semiconductor integrated circuit is in an ordinary use state after assembly into the system, the first power supply voltage is applied to the power supply pads 25a and 28a, and the second power supply voltage is applied to the power supply pads 25b, 28b, 30a, 30b, 32a and 32b. By implementing wire bonding in this way, after the semiconductor integrated circuit has been assembled into the system, the drive voltage is delivered through the drive voltage supply lines 41a and 42a and and the drive voltage supply line 34b. Accordingly, no current flows in the test ECL input buffer circuit 23ᵢ (i = 1, ... n) and the test ECL output buffer circuit 24ᵢ (i = 1, ... n). As a result, power uselessly consumed can be reduced. Thus, an increase in the power consumption can be prevented to a higher degree as compared to the conventional semiconductor integrated circuit.

It is to be noted that while it has been described in both the above-described embodiments that the number of power supplies for the ordinary input/output buffers and the test input/output buffers is equal to 2, in the case where the number of drive power supplies is m (≧ 2), an approach described below may be employed:
a) to connect one of a number m of test drive voltage supply lines for delivering drive voltages to test ECL input buffers commonly to a corresponding one of a number m of ordinary drive voltage supply lines for delivering drive voltages to the ordinary ECL input buffers, or to provide test drive voltage supply lines independently of the ordinary drive voltage supply lines, and
b) to connect one of a number m of test drive voltage supply lines for delivering drive voltages to test ECL output buffers commonly to a corresponding one of a number m of ordinary drive voltage supply lines for delivering drive voltages to the ordinary ECL output buffers, or to provide test drive voltage supply lines independently of the normal drive voltage supply lines. In addition, when the semiconductor integrated circuit is in an ordinary use state after having been assembled into the system, an approach is employed such that the same voltages are delivered to the test drive voltage supply lines for delivering drive voltages to the test ECL input buffers and the test ECL output buffers, respectively. It is a matter of course that, also when such an approach is employed, effects and/or advantages similar to those of the above-described embodiments can be provided.

Reference signs in the claims are intended for better understanding and shall not limit the scope.

## Claims

1. A semiconductor integrated circuit (40, 50) comprising:
a plurality of ECL input buffers (21₁-21ₙ) for inputting a signal of the ECL level from the external and having first and second drive voltage supply lines (41a, 41b);
a plurality of ECL output buffers (22₁-22ₙ) for outputting a signal of said ECL level to the external and having third and fourth drive voltage supply lines (42a, 42b);
a plurality of test ECL input buffers (23₁-23ₙ) for inputting a test signal of said ECL level from the external when said semiconductor integrated circuit is being assembled and having fifth and sixth drive voltage supply lines (43a, 43b);
a plurality of test ECL output buffers (24₁-24ₙ) for outputting a test signal of said ECL level to the external when said semiconductor integrated circuit (40, 50) is being assembled and having seventh and eighth drive voltage supply lines (44a, 44b);
a plurality of power supplies for supplying a first drive voltage and a second drive voltage to said buffers for driving same;
wherein in an ordinary use state after said semiconductor integrated circuit (40, 50) has been assembled, said first drive voltage is supplied to said first and third drive voltage supply lines (41a, 42a), and said second drive voltage is supplied to said second, fourth, fifth, sixth, seventh and eighth drive voltage supply lines (41b, 42b, 43a, 43b, 44a, 44b) by implemented wire bonding;
whereas when said semiconductor integrated circuit (40, 50) is being assembled and is subject to test, said first drive voltage is supplied to said fifth and seventh drive voltage supply lines (43a, 44a), and said second drive voltage is supplied to said sixth and eighth drive voltage supply lines (43b, 44b).

2. A semiconductor integrated circuit (50) as set forth in claim 1, wherein said second, fourth, sixth, and eighth drive voltage supply lines form a common drive voltage supply line (34b).

3. A semiconductor integrated circuit as set forth in claim 1, wherein one of said fifth and sixth drive voltage supply lines is common with a corresponding one of said first and second drive voltage supply lines.

4. A semiconductor integrated circuit as set forth in claim 1, wherein one of said seventh and eight drive voltage supply lines is common with a corresponding one of said third and fourth drive voltage supply lines.

5. A semiconductor integrated circuit as set forth in claim 1, wherein said fifth and sixth drive voltage supply lines (43a,43b) are separately formed on a large scale integrated circuit (40) independently of said first and second drive supply lines (41a,41b).

6. A semiconductor integrated circuit as set forth in claim 1, wherein said seventh and eighth drive voltage supply lines (44a,44b) are separately formed on a large scale integrated circuit (40) independently of said third and fourth drive voltage supply lines (42a,42b).

7. A semiconductor integrated circuit as set forth in claim 1, wherein said plurality of power supplies comprises two power supplies for driving said ECL input buffers (21₁-21ₙ) and said test ECL input buffers (23₁-23ₙ), and wherein said plurality of power supplies also comprises two power supplies for driving said ECL output buffers (22₁-22ₙ) and said test ECL output buffers (24₁-24ₙ).

8. A semiconductor integrated circuit as set forth in claim 1, wherein said ECL input buffers (21₁-21ₙ) and/or said test ECL input buffers (23₁-23ₙ) perform a logical operation on said signal of said ECL level inputted thereto thus to output a signal of the CMOS level, and wherein said ECL output buffers (22₁-22ₙ) and/or said test ECL output buffers (24₁-24ₙ) perform a logical operation on a signal of said CMOS level inputted thereto thus to output said signal of said ECL level.

## Patentansprüche

1. Integrierte Halbleiterschaltung (40, 50), welche aufweist:
mehrere ECL-Eingangspuffer (21₁-21ₙ) zur Eingabe eines Signals auf den ECL-Pegel von außen, welche erste und zweite Treiberspannungsversorgungsleitungen (41a, 41b) aufweisen;
mehrere ECL-Ausgangspuffer (22₁-22ₙ) zur Ausgabe eines Signals auf den ECL-Pegel nach außen, welche dritte und vierte Treiberspannungsversorgungsleitungen (42a, 42b) aufweisen;
mehrere Test-ECL-Eingangspuffer (23₁-23ₙ) zur Eingabe eines Testsignals auf dem ECL-Pegel von außen, wenn die integrierte Halbleiterschaltung zusammengebaut wird, welche fünfte und sechste Treiberspannungsversorgungsleitungen (43a, 43b) aufweisen;
mehrere Test-ECL-Ausgangspuffer (24₁-24ₙ) zur Ausgabe eines Testsignals auf dem ECL-Pegel nach außen, wenn die integrierte Halbleiterschaltung (40, 50) zusammengebaut wird, welche siebte und achte Treiberspannungsversorgungsleitungen (44a, 44b) aufweisen;
mehrere Stromversorgungen zum Liefern einer ersten Treiberspannung und einer zweiten Treiberspannung an die Puffer, um diese zu treiben;
wobei in einem normalen Benutzungszustand nach dem Zusammenbau der integrierten Halbleiterschaltung (40, 50) die erste Treiberspannung an die ersten und dritten Treiberspannungsversorgungsleitungen (41a, 42a) geliefert wird, und die zweite Treiberspannung an die zweiten, vierten, fünften, sechsten, siebten und achten Treiberspannungsversorgungsleitungen (41b, 42b, 43a, 43b, 44a, 44b) durch ausgeführte Drahtverbindungen geliefert wird;
wogegen dann, wenn die integrierten Halbleiterschaltung (40, 50) zusammengebaut und getestet wird, die erste Treiberspannung an die fünften und siebten Treiberspannungsversorgungsleitungen (43a, 44a) geliefert wird, und die zweite Treiberspannung an die sechsten und achten Treiberspannungsversorgungsleitungen (43b, 44b) geliefert wird.

2. Integrierte Halbleiterschaltung (50) nach Anspruch 1,
bei welcher die zweiten, vierten, sechsten und achten Treiberspannungsversorgungsleitungen eine gemeinsame Treiberspannungsversorgungsleitung (34b) bilden.

3. Integrierte Halbleiterschaltung nach Anspruch 1,
bei welcher entweder die fünfte oder die sechste Treiberspannungsversorgungsleitung gemeinsam mit einer entsprechenden unter den ersten und zweiten Treiberspannungsversorgungsleitungen ausgeführt ist.

4. Integrierte Halbleiterschaltung nach Anspruch 1,
bei welcher entweder die siebte oder die achte Treiberspannungsversorgungsleitung gemeinsam mit einer entsprechenden unter den dritten und vierten Treiberspannungsversorgungsleitungen ausgeführt ist.

5. Integrierte Halbleiterschaltung nach Anspruch 1,
bei welcher die fünften und sechsten Treiberspannungsversorgungsleitungen (43a, 43b) getrennt auf einer hochintegrierten Schaltung (40) unabhängig von den ersten und zweiten Treiberspannungsversorgungsleitungen (41a, 41b) vorgesehen sind.

6. Integrierte Halbleiterschaltung nach Anspruch 1,
bei welcher die siebten und achten Treiberspannungsversorgungsleitungen (44a, 44b) getrennt auf einer hochintegrierten Schaltung (40) unabhängig von den dritten und vierten Treiberspannungsversorgungsleitungen (42a, 42b) vorgesehen sind.

7. Integrierte Halbleiterschaltung nach Anspruch 1,
bei welcher die mehreren Stromversorgungen zwei Stromversorgungen zum Treiben der ECL-Eingangspuffer (21₁-21ₙ) und der Test-ECL-Eingangspuffer (23₁-23ₙ) umfassen, und bei welcher die mehreren Stromversorgungen weiterhin zwei Stromversorgungen zum Treiben der ECL-Ausgangspuffer (22₁-22ₙ) und der Test-ECL-Ausgangspuffer (24₁-24ₙ) umfassen.

8. Integrierte Halbleiterschaltung nach Anspruch 1,
bei welcher die ECL-Eingangspuffer (21₁-21ₙ) und/oder die Test-ECL-Eingangspuffer (23₁-23ₙ) eine logische Operation mit dem Signal auf dem ECL-Pegel durchführen, welches in sie eingegeben wird, um auf diese Weise ein Signal auf dem CMOS-Pegel auszugeben, und bei welcher die ECL-Ausgangspuffer (22₁-22ₙ) und/oder die Test-ECL-Ausgangspuffer (24₁-24ₙ) eine logische Operation bei einem Signal auf dem CMOS-Pegel durchführen, welches in sie eingegeben wird, um auf diese Weise das Signal auf dem ECL-Pegel auszugeben.

## Revendications

1. Circuit intégré à semi-conducteur (40, 50) comprenant :
- une pluralité de tampons d'entrée ECL (21₁ à 21ₙ) pour fournir un signal de niveau ECL de l'extérieur et possédant des première et seconde lignes de source de tension d'attaque (41a, 41b);
- une pluralité de tampons de sortie ECL (22₁ à 22ₙ) pour fournir un signal dudit niveau ECL à l'extérieur et possédant des troisième et quatrième lignes de source de tension d'attaque (42a, 42b);
- une pluralité de tampons d'entrée ECL de test (23₁ à 23ₙ) pour entrer un signal de test dudit niveau ECL de l'extérieur lorsque ledit circuit intégré à semi-conducteur est monté, et possédant des cinquième et sixième lignes de source de tension d'attaque (43a, 43b);
- une pluralité de tampons de sortie ECL de test (24₁ à 24ₙ) pour fournir un signal de test dudit niveau ECL à l'extérieur lorsque ledit circuit intégré à semi-conducteur (40, 50) est monté, et possédant des septième et huitième lignes de source de tension d'attaque (44a, 44b);
- une pluralité de source de puissance pour fournir une première tension d'attaque et une seconde tension d'attaque auxdits tampons pour leur attaque;
circuit dans lequel, dans un mode usuel d'utilisation après le montage dudit circuit intégré à semi-conducteur (40, 50), ladite première tension d'attaque est fournie auxdites première et troisième lignes de source de tension d'attaque (41a, 42a) et ladite seconde tension d'attaque est fournie auxdites seconde, quatrième, cinquième, sixième, septième et huitième lignes de source de tension d'attaque (41b, 42b, 43a, 43b, 44a, 44b) par mise en oeuvre d'une liaison par câblage;
tandis que lorsque ledit circuit intégré à semi-conducteur (40, 50) est monté et est soumis à un test, ladite première tension d'attaque est fournie auxdites cinquième et septième lignes de source de tension d'attaque (43, 44a) et ladite seconde tension d'attaque est fournie auxdites sixième et huitième lignes de source de tension d'attaque (43b, 44b).

2. Circuit intégré à semi-conducteur (50) selon la revendication 1, dans lequel lesdites seconde, quatrième, sixième et huitième lignes de source de tension d'attaque forment une ligne commune de source de tension d'attaque (34b).

3. Circuit intégré à semi-conducteur (50) selon la revendication 1, dans lequel une desdites cinquième et sixième lignes de source de tension d'attaque est commune avec une ligne correspondante desdites première et seconde lignes de source de tension d'attaque.

4. Circuit intégré à semi-conducteur (50) selon la revendication 1, dans lequel une desdites septième et huitième lignes de source de tension d'attaque est commune avec une ligne correspondante desdites troisième et quatrième lignes de source de tension d'attaque.

5. Circuit intégré à semi-conducteur (50) selon la revendication 1, dans lequel lesdites cinquième et sixième lignes de source de tension d'attaque (43a, 43b) sont formées, de façon séparée, sur un circuit intégré à forte intégration (40) indépendamment desdites première et seconde lignes de source d'attaque (41a, 41b).

6. Circuit intégré à semi-conducteur (50) selon la revendication 1, dans lequel lesdites septième et huitième lignes de source de tension d'attaque (44a, 44b) sont formées, de façon séparée, sur un circuit intégré à forte intégration (40) indépendamment desdites troisième et quatrième lignes de source de tension d'attaque (42a, 42b).

7. Circuit intégré à semi-conducteur (50) selon la revendication 1, dans lequel ladite pluralité de sources de puissance comprend deux sources de puissance pour l'attaque desdits tampons d'entrée ECL (21₁ à 21ₙ) et desdits tampons d'entrée ECL de test (23₁ à 23ₙ), et dans lequel ladite pluralité de sources de puissance comprend, de même, deux sources de puissance pour l'attaque desdits tampons de sortie ECL (22₁ à 22ₙ) et desdits tampons de sortie ECL de test (24₁ à 24ₙ).

8. Circuit intégré à semi-conducteur (50) selon la revendication 1, dans lequel lesdits tampons d'entrée ECL (21₁ à 21ₙ) et/ou lesdits tampons d'entrée ECL de test (23₁ à 23ₙ) effectuent une opération logique sur ledit signal dudit niveau ECL fourni afin de générer un signal de niveau CMOS, et dans lequel lesdits tampons de sortie ECL (22₁ à 22ₙ) et/ou lesdits tampons de sortie ECL de test (24₁ à 24ₙ) effectuent une opération logique sur un signal dudit niveau CMOS entré afin de générer ledit signal dudit niveau ECL.
